(19) Europäisches Patentamt

European Patent Office

Office européen des brevets

(11) **EP 1 249 025 B1**

(12) **EUROPÄISCHE PATENTSCHRIFT**

(45) Veröffentlichungstag und Bekanntmachung des Hinweises auf die Patenterteilung:
**07.04.2004 Patentblatt 2004/15**

(51) Int Cl.[7]: **H01F 17/00**, H01F 27/36, H01L 23/64

(21) Anmeldenummer: 01915149.7

(22) Anmeldetag: **19.01.2001**

(86) Internationale Anmeldenummer:
**PCT/EP2001/000584**

(87) Internationale Veröffentlichungsnummer:
**WO 2001/054148 (26.07.2001 Gazette 2001/30)**

(54) **SPULE UND SPULENSYSTEM ZUR INTEGRATION IN EINE MIKROELEKTRONISCHE SCHALTUNG SOWIE MIKROELEKTRONISCHE SCHALTUNG**

COIL AND COIL SYSTEM TO BE INTEGRATED IN A MICROELECTRONIC CIRCUIT, AND A MICROELECTRONIC CIRCUIT

BOBINE ET SYSTEME DE BOBINE A INTEGRER DANS UN CIRCUIT MICRO-ELECTRONIQUE ET CIRCUIT MICRO-ELECTRONIQUE CORRESPONDANT

(84) Benannte Vertragsstaaten:
**AT BE CH CY DE DK ES FI FR GB GR IE IT LI LU MC NL PT SE TR**

(30) Priorität: **20.01.2000 DE 10002377**

(43) Veröffentlichungstag der Anmeldung:
**16.10.2002 Patentblatt 2002/42**

(73) Patentinhaber: **Infineon Technologies AG**
**81669 München (DE)**

(72) Erfinder:
- **BERTHOLD, Jörg**
  **81675 München (DE)**
- **SEWALD, Dieter**
  **83052 Bruckmühl (DE)**
- **TIEBOUT, Marc**
  **81739 München (DE)**

(74) Vertreter: **Ginzel, Christian et al**
**Zimmermann & Partner,**
**Postfach 33 09 20**
**80069 München (DE)**

(56) Entgegenhaltungen:
EP-A- 0 555 994          EP-A- 0 725 407
EP-A- 0 834 922          WO-A-98/50956
US-A- 3 614 554

- **BRAUN A E: "Copper electroplating enters mainstream processing" SEMICONDUCTOR INTERNATIONAL, APRIL 1999, CAHNERS PUBLISHING, USA, Bd. 22, Nr. 4, Seiten 58-60, 62, 64, 66, XP001001553 ISSN: 0163-3767 in der Anmeldung erwähnt**

**Beschreibung**

Die vorliegende Erfindung betrifft eine Spule sowie ein Spulensystem zur Integration in eine mikroelektronische Schaltung. Weiterhin betrifft die Erfindung eine mikroelektronische Schaltung.

Bei einer ganzen Reihe von Schaltungstypen, beispielsweise bei Oszillatoren, Verstärkern, Mischern oder dergleichen, werden Induktivitäten (Spulen) benötigt. Diese gehören zu den Bauelementtypen, bei deren Integration auf einem Chip zusammen mit den übrigen Schaltungsteilen Probleme auftreten können. Dies führte bisher dazu, daß Induktivitäten in vielen Fällen noch als diskrete Bauelemente eingesetzt werden, da sie als auf Chips integrierte Spulenformen ansonsten Nachteile aufweisen würden. Bei sehr hohen Frequenzen, das heißt bei Frequenzen in Bereichen weit oberhalb von 1 GHz, müssen auf jeden Fall integrierte Induktivitäten verwendet werden, da dann über die Zuleitungen der diskreten Spulen eine Sighalübertragung sehr schwierig wird.

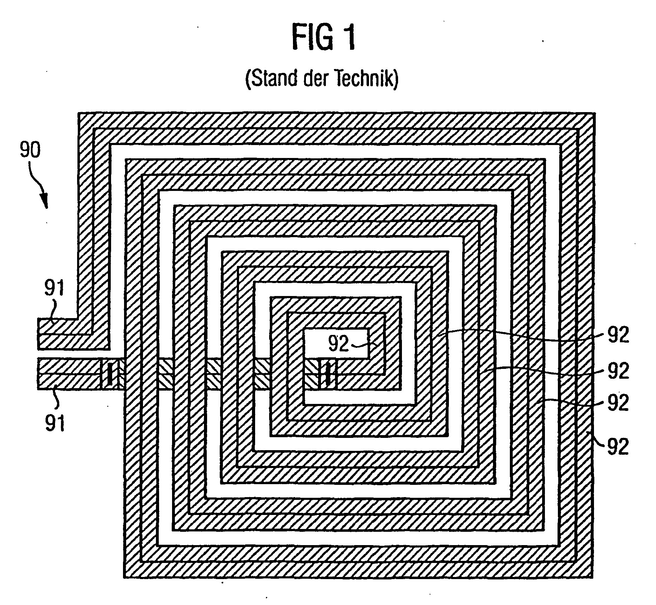

In Figur 1 ist eine typische Spulenimplementierung dargestellt, wie sie aus dem Stand der Technik bekannt ist. Eine Metallbahn durchläuft eine Spirale, wodurch eine Anzahl von Windungen mit zunehmenden Radien entsteht. Stehen auf dem Chip mehrere Metallagen zur Verfügung, können derartige Spiralen gestapelt werden. Durch eine Reihenschaltung addieren sich die Induktivitäten. Bei einer Parallelschaltung werden Bahnwiderstände verringert, was zu niedrigeren Leistungsverlusten führt. Diese bekannten Spulen, beziehungsweise Spulenformen, weisen jedoch eine Reihe von Nachteilen auf. Ein besonderer Nachteil ergibt sich beispielsweise aus dem Durchgriff des magnetischen Feldes in das Substrat, üblicherweise ein Siliziumsubstrat. In der Regel wird in modernen CMOS-Technologien ein relativ niederohmiges Substrat eingesetzt, was einen relativ hohen Induktionsstrom zur Folge hat, der durch das magnetische Wechselfeld verursacht wird. Dies führt zu relativ hohen Verlusten, was bedeutet, daß die Güte der integrierten Induktivität (Spule) relativ gering ist. Im Gigahertz-Frequenzbereich ist die Güte beispielsweise um Größenordnungen niedriger im Vergleich zu diskreten Spulen. Da die Spulengüte eine wichtige Performancegröße von Analogschaltungen ist, besteht das Bedürfnis, die Güte der Spulen zu verbessern.

Die vorstehend beschriebenen Spulentypen werden beispielsweise in Standard-CMOS-Prozessen eingesetzt. Bei solchen Prozessen wird relativ niederohmiges Substrat verwendet, was die entsprechend geringen Spulengüten zur Folge hat. Wird statt dessen ein hochohmiges Substrat verwendet, sinken die Verluste und die Spulengüte steigt an. Ein hochohmiges Substrat kann allerdings nachteilige Auswirkungen auf eine ganze Reihe von Transistoreigenschaften haben. Bei Verwendung hochohmiger Substrate wäre auf jeden Fall kein Standard-CMOS-Prozeß mehr möglich, so daß eine andere Prozeßführung erforderlich würde. Dies ist jedoch nicht wünschenswert.

Eine weitere Möglichkeit zur Verbesserung der Spulengüte besteht darin, daß das Substratmaterial direkt unter der Spule durch einen geeigneten Ätzprozeß entfernt wird. Zwischen den Spulenebenen und dem Substrat kann dann eine Metallschicht aufgebracht werden. Durch Einbringen von Schlitzen können Wirbelströme unterbunden werden, wobei gleichzeitig eine Abschirmung zum Substrat erreicht wird. Nachteilig bei einer solchen Lösung ist jedoch, daß für Spulenwindungen eine Metallebene weniger zur Verfügung steht. Außerdem lassen sich damit nur geringfügige Verbesserungen der Spulengüte erzielen.

Ein weiterer Nachteil der bekannten Spulen liegt in dem relativ großen Flächenbedarf. Die in Figur 1 gezeigte Spulengeometrie erfordert bei einer Induktivität von ca. 9 nHz eine Fläche von 0,3 * 0,3 mm. Wird eine größere Induktivität benötigt, steigt der Flächenbedarf proportional an.

In der EP-A-0 725 407 ist eine dreidimensionale, in einer mikroelektronischen Schaltung integrierte Spule beschrieben, bei der die Spulenachse horizontal zur Chipoberfläche liegt. Die Spule weist eine oder mehrere Windungen auf, wobei die Windungen durch Leiterbahnen einer unteren Metallisierungsebene und Leiterbahnen einer oberen Metallisierungsebene sowie diese verbindende Via-Kontakte hergestellt werden. Als "Via" wird allgemein ein Verbindungsstück zwischen zwei Metallebenen verstanden. Bei der bekannten Lösung wird die Induktivität durch einen zwischen die Leiterbahnen und Via-Kontakte eingebrachten Kern aus höher permeablem Material erreicht, der ein grundlegendes Merkmal dieser bekannten Lösung darstellt. Bei der in der EP-A-0 725 407 offenbarten Spulengeometrie dringt nur noch ein kleiner Teil des Magnetfeldes in das Substrat ein, so daß die hiermit verbundenen Verluste kleiner werden und somit die Güte der Spule verbessert wird. Trotz dieses Vorteils wird diese Spulengeometrie bisher nicht eingesetzt. Dies liegt beispielsweise daran, daß zur Zeit kein halbleiterkompatibles Kernmaterial zur Verfügung steht. Zudem weisen alle hochpermeablen Materialien bei hohen Frequenzen hohe Ummagnetisierungsverluste auf, die wiederum die Spulengüte begrenzen. Des weiteren sind bei den üblicherweise verwendeten Metallisierungen die Via-Widerstände zu hoch.

Ausgehend vom genannten Stand der Technik liegt der vorliegenden Erfindung die Aufgabe zu Grunde, eine Spule und ein Spulensystem zur Integration in eine mikroelektronische Schaltung, sowie eine mikroelektronische Schaltung bereitzustellen, bei der die zum Stand der Technik beschriebenen Nachteile vermieden werden. Insbesondere soll erreicht werden, daß Spulen, beziehungsweise Spulensysteme, hoher Güte auf einfache und kostengünstige Weise hergestellt und in mikroelektronische Schaltungen integriert werden können.

Diese Aufgabe wird gemäß dem ersten Aspekt der vorliegenden Erfindung gelöst durch eine Spule zur Integration in eine mikroelektronische Schaltung, mit einer oder mehreren Windungen, wobei die Windung(en) durch zumindest Segmente von zwei Leiterbahnen, die in jeweils räumlich voneinander getrennten Metallisierungsebenen ausgebildet sind, sowie diese Leiterbahn (en) und/oder Leiterbahnsegmente verbindende Via-Kontakte gebildet ist/sind. Die Spule ist erfindungsgemäß dadurch gekennzeichnet, daß jeder Via-Kontakt aus einem Stapel von zwei oder mehr übereinander angeordneten Via-Elementen gebildet ist.

Dadurch wird eine leicht in mikroelektronische Schaltungen integrierbare Spule hoher Güte geschaffen. Die erfindungsgemäße Spule geht in ihrem Grundaufbau von der in der EP-A-0 725 407 beschriebenen Spule aus. Wegen des geringen Durchgriffs von Streufeldern ins Substrat können mit einer solchen Spulengeometrie hohe Spulengüten realisiert werden. Die Formel für die Induktivität bei einer solchen Spulengeometrie lautet:

$$L = \mu 0 * \mu r * A * N^2 / l$$

Dabei ist $\mu 0$ die Permeabilitäts-Konstante (1.2 $E^{-6}$ H/M) und $\mu r$ die relative Permeabilitätszahl (ca. 100.000 bei ferromagnetischen Materialien). A ist die Querschnittsfläche der Spule senkrecht zur Spulenachse, N ist die Windungszahl und 1 ist die Länge der Spule. Aus den zum Stand der Technik beschriebenen Gründen wird bei der erfindungsgemäßen Spule auf einen magnetischen Kern verzichtet. Statt dessen ist es ein Grundgedanke der vorliegenden Erfindung, daß die Querschnittsfläche der Spule vergrößert wird. Bei der in der EP-A-0 725 407 beschriebenen Lösung wären dazu sehr lange Leiterbahnen erforderlich, um bei den in Standardmetallisierungen üblichen Dicken der Via-Kontakte (Intermetall-Dielektrikas) von 0,5 $\mu$m bis 0,3 $\mu$m Flächen von ca. 10 - 20 $\mu$m$^2$ zu realisieren. Diese langen Leiterbahnen weisen jedoch einen entsprechend hohen Bahnwiderstand auf, wodurch die Güte der Spule reduziert wird. Wählt man statt dessen eine höhere Windungszahl, so steigt ebenfalls entsprechend der längeren Leitungslänge der Bahnwiderstand an.

Durch die erfindungsgemäße Ausgestaltung der Via-Kontakte in Form von Stapeln mit jeweils zwei oder mehr übereinander angeordneten Via-Elementen, kann der Querschnitt der Spule und damit deren Güte auf einfache Weise vergrößert, beziehungsweise verbessert, werden. Durch die Verwendung mehrerer gestapelter Via-Elemente als Via-Kontakt kann erreicht werden, daß eine Standardmetallisierung zur Herstellung der Spule verwendet werden kann. Das bedeutet, daß zur Vergrößerung der Querschnittsfläche kein besonders dickes Intermetall-Dielektrikum mit entsprechend tiefen Via-Kontakten eingesetzt werden muß. Die Erzeugung besonders tiefer, von den Standardmetallisierungen abweichenden Via-Kontakten wäre nur mit Hilfe von Sonderprozessen möglich, so daß die Herstellung derartiger Spulen konstruktiv aufwendig und kostenintensiv wäre. Ein weiterer Vorteil der erfindungsgemäßen Spule liegt darin, daß relativ große Spulenquerschnittsflächen mit kurzen Leiterbahnen erzielt werden können. Weiterhin kann auf einen zusätzlichen magnetischen Kern verzichtet werden, der eine der Grundvoraussetzungen der in der EP-A-0 725 407 offenbarten Lösung darstellte.

Bei modernen Siliziumtechnologien stehen üblicherweise 4 bis 6 Metallebenen zur Verfügung. Das bedeutet, daß der vertikale Abstand zwischen der untersten und der obersten Metallage (Metallisierungsebene) bis zu 4 $\mu$m betragen kann. Wird nun in einer Standardmetallisierung die Verbindung zwischen oberer und unterer Metallisierungsebene nicht über einen - besonders langen - Via-Kontakt, sondern durch einen Stapel übereinander liegender Via-Elemente bewerkstelligt, beträgt die Höhe des Spulenquerschnitts gerade diese 4 $\mu$m. Wie weiter oben bereits dargelegt wurde, betrug der Abstand zwischen 2 Leiterbahnen der Spule bei bekannten Lösungen bisher etwa 0,5 $\mu$m.

In einem konkreten Beispiel kann die erfindungsgemäße Spule eine oder mehrere Windungen aufweisen, wobei eine Windung jeweils durch Leiterbahnstücke, beziehungsweise Leiterbahnen, auf einer untersten Metallisierungsebene und auf einer obersten Metallisierungsebene sowie durch die als Vertikalverbindungen dienenden Via-Kontakte aus Stapeln zweier oder mehrerer Via-Elemente zwischen diesen Metallisierungsebenen gebildet wird.

Bevorzugte Ausführungsformen der erfindungsgemäßen Spule ergeben sich aus den Unteransprüchen.

Vorteilhaft können die Via-Kontakte zumindest im wesentlichen senkrecht zu den Leiterbahnen und/ oder Leiterbahnsegmenten ausgerichtet sein.

Vorzugsweise können zumindest zwischen einzelnen Via-Elementen eines Stapels Bestandteile einer Metallisierungsebene vorgesehen sein.

Durch derart ausgebildete Via-Kontakte ist es möglich, daß zur Herstellung der Spule eine Standardmetallisierung verwendet werden kann. Dabei wurde überraschenderweise herausgefunden, daß derart ausgebildete Via-Kontakte gegenüber ansonsten notwendigen dickeren einteiligen Via-Kontakten keine Nachteile aufweisen.

Vorzugsweise begrenzen die Leiterbahn(en) und/oder die Leiterbahnsegmente sowie die Via-Kontakte den Querschnitt der Spule. Diese Querschnittsfläche ist bestimmt von dem vertikalen Abstand zwischen den die Leiterbahn(en) beziehungsweise die Leiterbahnsegmente bildenden Metallisierungsebenen sowie die jeweilige Länge der Leiterbahn(en) beziehungsweise Leiterbahnsegmente auf diesen Metallisierungsebenen. Diese Längen sind wegen des Bahnwiderstands der Leitungen in Grenzen frei wählbar. Mit längeren Leitungsstücken auf den entsprechenden Metallisierungsebenen sind somit entsprechend größere Querschnittsflächen möglich.

Vorteilhaft können die die Windung oder Windungen der Spule bildende(n) Leiterbahn(en) und/oder Leiterbahnsegmente in einem Abstand von etwa 4 μm zueinander angeordnet sein. Wie weiter oben bereits erwähnt wurde, ergibt sich ein solcher Abstand beispielsweise dann, wenn etwa 4 bis 6 Metallisierungsebenen zur Verfügung stehen.

In weiterer Ausgestaltung können die Leiterbahn(en) und/oder Leiterbahnsegmente und/oder die Via-Elemente und/oder die zwischen einzelnen Via-Elementen vorgesehenen Bestandteile einer Metallisierungsebene aus Kupfer, insbesondere aus elektrolytisch abgeschiedenem Kupfer, gebildet sein. Bei Verwendung von Kupfer weisen die Bestandteile nur einen geringen Widerstand auf. Wird Kupfer als Leiterbahnmaterial eingesetzt, bleibt auch der Widerstand des als Stapel aus zwei oder mehr Via-Elementen ausgebildeten Via-Kontakts gering. Dieser Widerstand kann beispielsweise 3 Ω bei einer 0.18 μm-Technologie betragen. Durch n-Via-Stapel kann mittels Parallelschaltung dieser Widerstand auf 1/n reduziert werden. Wird zur Herstellung der Spule eine Standardmetallisierung mit Kupfer verwendet, können bei diesem Verfahren auch die vertikalen Verbindungsstücke zwischen den Metallebenen (die Via-Elemente) mit dem niederohmigen Kupfer aufgefüllt werden.

Besonders vorteilhaft wird mittels eines elektrolytischen Verfahrens abgeschiedenes Kupfer eingesetzt. Diese Herstellung des Kupfers ist an sich bereits bekannt. Sie ist beispielsweise in dem Aufsatz "Copper Electroplating" von Alexander E. Braun beschrieben, der in der Zeitschrift "Semiconductor International", April 1999, Seiten 58ff veröffentlicht ist, und dessen Offenbarungsgehalt insoweit in die Beschreibung der vorliegenden Erfindung einbezogen wird.

Vorteilhaft kann die Spule zur Integration in einer auf und/oder in einem Substrat angeordneten mikroelektronischen Schaltung ausgebildet sein, wobei die Spulenachse horizontal zur Substratoberfläche ausgerichtet ist. Dadurch kann der Durchgriff von Streufeldern in das Substrat verringert werden, was zu höheren Spulengüten führt.

Vorzugsweise kann der Spulenanfang und das Spulenende der Spule benachbart zueinander angeordnet sein, so daß die Spulenachse eine zumindest in etwa geschlossene Linie, insbesondere eine kreisförmige Linie, bildet. Durch eine solche Form der Spulenachse werden die Streuverluste reduziert, was zu einer weiteren Verbesserung der Spulengüte führt. Insbesondere dann, wenn die Spulenachse eine in etwa kreisförmige Linie bildet, gestattet es diese Geometrie, daß die Spule in geeigneter Weise lateral abgeschirmt werden kann, wie dies im weiteren Verlauf der Beschreibung im Hinblick auf das erfindungsgemäße Spulensystem näher erläutert wird.

Gemäß dem zweiten Aspekt der vorliegenden Erfindung wird ein Spulensystem zur Integration in einer mikroelektronischen Schaltung bereitgestellt, das erfindungsgemäß gekennzeichnet ist durch eine oder mehrere wie vorstehend beschriebene erfindungsgemäße Spulen. Zu den Vorteilen, Wirkungen, Effekten und der Funktionsweise des erfindungsgemäßen Spulensystems wird ebenfalls auf die vorstehenden Ausführungen zur erfindungsgemäßen Spule vollinhaltlich Bezug genommen und hiermit verwiesen.

Vorteilhafte Ausführungsformen des erfindungsgemäßen Spulensystems ergeben sich aus den Unteransprüchen.

Vorzugsweise kann zur Abschirmung der Spule(n) eine Anzahl von Via-Stapeln, die jeweils aus einem oder mehreren Via-Element(n) gebildet sind, vorgesehen sein. Diese Via-Stapel sind vorteilhaft außerhalb der Spule(n), insbesondere außerhalb der Spulenperipherie, um diese herum angeordnet. Wird eine ganze Reihe von Via-Stapeln nebeneinander angeordnet, um eine Spule herumgelegt, so kann dadurch eine effiziente laterale Abschirmung der Spule erreicht werden.

Vorteilhaft können die Via-Stapel in etwa senkrecht zur Spulenachse ausgerichtet sein.

In weiterer Ausgestaltung kann zumindest eine Abschirmebene zur vertikalen Abschirmung der Spule vorgesehen sein.

Beispielsweise kann die Abschirmebene als Metallebene ausgebildet sein.

In weiterer Ausgestaltung kann die Abschirmebene als Poly-Siliziumfläche oder als Struktur mit einem hochdotierten Substrat ausgebildet sein.

Stehen genügend Metallisierungsebenen zur Verfügung, so kann die oberste Metallisierungsebene beispielsweise als Abschirmebene zum vertikalen Abschirmen der Spule nach oben verwendet werden. Vorzugsweise kann diese Metallebene als geschlitzte Fläche ausgebildet sein, um Wirbelströme zu unterbinden. Für eine Abschirmung der Spule nach unten kann beispielsweise eine Abschirmebene dienen, die als Poly-Siliziumschicht oder Struktur mit hochdotiertem Substrat ausgebildet ist. Auch diese untere Abschirmebene kann vorteilhaft als geschlitzte Fläche ausgebildet sein.

Gemäß einem dritten Aspekt der vorliegenden Erfindung wird eine mikroelektronische Schaltung bereitgestellt, die eine Anzahl integrierter Bauelemente aufweist, wobei zumindest eines dieser Bauelemente als Induktivität ausgebildet ist. Die mikroelektronische Schaltung ist erfindungsgemäß dadurch gekennzeichnet, daß das als Induktivität vorgesehene Bauelement als eine wie vorstehend beschriebene erfindungsgemäße Spule und/oder als ein wie vorstehend beschriebenes erfindungsgemäßes Spulensystem ausgebildet ist. Dadurch lassen sich mikroelektronische Schaltungen schaffen, in denen Spulen, beziehungsweise Spulensysteme, hoher Güte integriert werden können, so daß solche mikroelektronische Schaltungen auch bei sehr hohen Frequenzen in Bereichen weit oberhalb von 1 GHz eingesetzt werden können. Zu den Vorteilen, Wirkungen, Effekten und der Funktionsweise der erfindungsgemäßen mikroelektronischen Schaltung wird ebenfalls auf die vorstehenden Ausführungen zur erfindungsgemäßen Spule sowie zum erfindungsgemäßen Spulensystem vollinhaltlich Bezug genommen und hiermit verwiesen.

Vorteilhaft kann die mikroelektronische Schaltung auf und/oder in einem Chip ausgebildet sein, wobei der Chip aus einem Substrat und wenigstens einer Oxidschicht gebildet ist.

Vorzugsweise kann die Spule beispielsweise das Spulensystem innerhalb der Oxidschicht angeordnet sein. Auf diese Weise kann bei der Herstellung der Spule auf eine Standardmetallisierung zurückgegriffen werden.

Die Erfindung wird nun an Hand von Ausführungsbeispielen unter Bezugnahme auf die beiliegende Zeichnung näher erläutert. Es zeigen:

Figur 1     in schematischer Draufsicht eine aus dem Stand der Technik bekannte Spulenkonfiguration;

Figur 2     eine erste Ausführungsform einer Spule gemäß der vorliegenden Erfindung;

Figur 3     eine schematische Querschnittsansicht der erfindungsgemäßen Spule gemäß Figur 2, wobei die Spule in einer mikroelektronischen Schaltung integriert ist;

Figur 4     eine weitere Ansicht der erfindungsgemäßen Spule nach Figur 2,

Figur 5     eine schematische Querschnittsansicht der erfindungsgemäßen Spule nach Figur 4, in der der Verlauf der magnetischen Feldlinien dargestellt ist;

Figur 6     eine weitere Ausführungsform einer Spule gemäß der vorliegenden Erfindung;

Figur 7     eine schematische Draufsicht auf ein erfindungsgemäßes Spulensystem unter Verwendung einer Spule nach Figur 6;

Figur 8     eine Querschnittsansicht des erfindungsgemäßen Spulensystems entlang der in Figur 7 dargestellten Schnittlinie VIII-VIII;

Figur 9     eine weitere Ausführungsform eines erfindungsgemäßen Spulensystems unter Verwendung einer in Figur 6 dargestellten Spule; und

Figur 10     eine Querschnittsansicht des erfindungsgemäßen Spulensystems entlang der in Figur 9 dargestellten Schnittlinie X-X.

In Figur 1 ist eine Spule 90 dargestellt, wie sie aus dem Stand der Technik bekannt ist. Die Spule 90 weist eine Metallbahn 91 auf, die eine Spirale durchläuft, wodurch eine Anzahl von Windungen 92 mit zunehmenden Radien entsteht. Stehen mehrere Metallagen zur Verfügung, können die auf diese Weise ausgebildeten Spulen 90 übereinander gestapelt und anschließend entweder in Reihe oder parallel geschaltet werden. Derartige Spulen 90 weisen jedoch die im Hinblick auf die Beschreibungseinleitung genannten Nachteile auf.

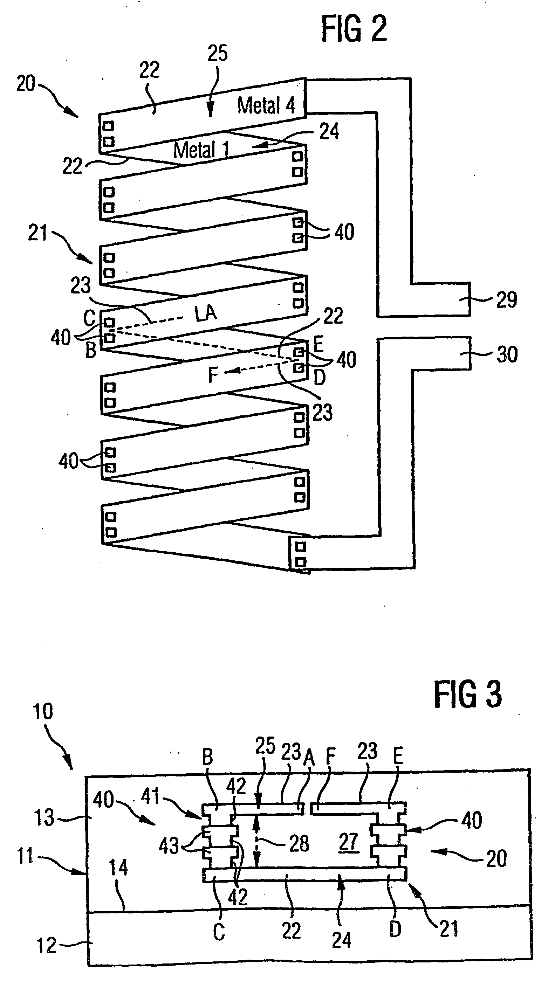

In den Figuren 2 und 3 ist eine erste Ausführungsform einer erfindungsgemäßen Spule 20 zur Integration in einer mikroelektronischen Schaltung 10 dargestellt. Wie sich insbesondere aus Figur 3 ergibt, ist die mikroelektronische Schaltung 10 in einem Chip 11 ausgebildet, der wiederum aus einem Substrat 12 und wenigstens einer Oxidschicht 13 gebildet ist. Die Oxidschicht 13 ist im vorliegenden Ausführungsbeispiel auf der Substratoberfläche 14 ausgebildet.

Die Spule 20 weist einen Spulenanfang 29 und ein Spulenende 30 sowie eine Anzahl von Windungen 21 auf. Jede Spulenwindung 21 wird durch Leiterbahnen 22 beziehungsweise Leiterbahnsegmente 23 gebildet. Die Leiterbahnen 22, beziehungsweise die Leiterbahnsegmente 23, werden durch eine untere Metallisierungsebene 24 sowie eine obere Metallisierungsebene 25 gebildet. Zur Verbindung der beiden Metallisierungsebenen 24, 25, beziehungsweise der Leiterbahnen 22 beziehungsweise Leiterbahnsegmente 23, sind vertikale Verbindungsstücke zwischen den Metallisierungsebenen 24, 25 vorgesehen, die als Via-Kontakte 40 bezeichnet werden. Alle Bestandteile der Windung(en) 21 bestehen aus Kupfer und weisen deshalb nur einen geringen Widerstand auf. Die von der Windung 21 umschlossene Spulenquerschnittsfläche 27 ist bestimmt von dem vertikalen Abstand 28 der oberen Metallisierungsebene 25 zur unteren Metallisierungsebene 24. Im vorliegenden Ausführungsbeispiel beträgt dieser Abstand in etwa 4 μm. Weiterhin wird die Spulenquerschnittsfläche 27 bestimmt durch die Länge der Leiterbahnen 22, beziehungsweise Leiterbahnsegmente 23, auf der unteren und oberen Metallisierungsebene 24, 25. Diese Längen sind wegen des Bahnwiderstands der Leitungen in Grenzen frei wählbar. Das bedeutet, daß mit längeren Leitungsstücken auf der unteren und oberen Metallisierungsebene 24, 25 entsprechend größere Querschnittsflächen möglich sind.

Um die Spule 20 mittels einer Standardmetallisierung herstellen zu können, ohne daß besonders tiefe Via-Kontakte erforderlich sind, die nur mittels eines aufwendigen und teuren Sonderprozesses herstellbar wären, weisen die Via-Kontakte 40 einen Stapel 41 aus jeweils zwei oder mehr Via-Elementen 42 auf. Zwischen den einzelnen Via-Elementen 42 befinden sich Bestandteile 43 verschiedener Metallisierungsebenen, die

zwischen der unteren und der oberen Metallisierungsebene 24, 25 ausgebildet sind. Wird Kupfer als Leiterbahnmaterial eingesetzt, das durch ein elektrolytisches Verfahren abgeschieden werden kann, so bleibt der Widerstand dieses Stapels 41 übereinander liegender Via-Elemente 42 mit dazwischen befindlichen Bestandteilen 43 von Metallisierungsebenen dennoch gering.

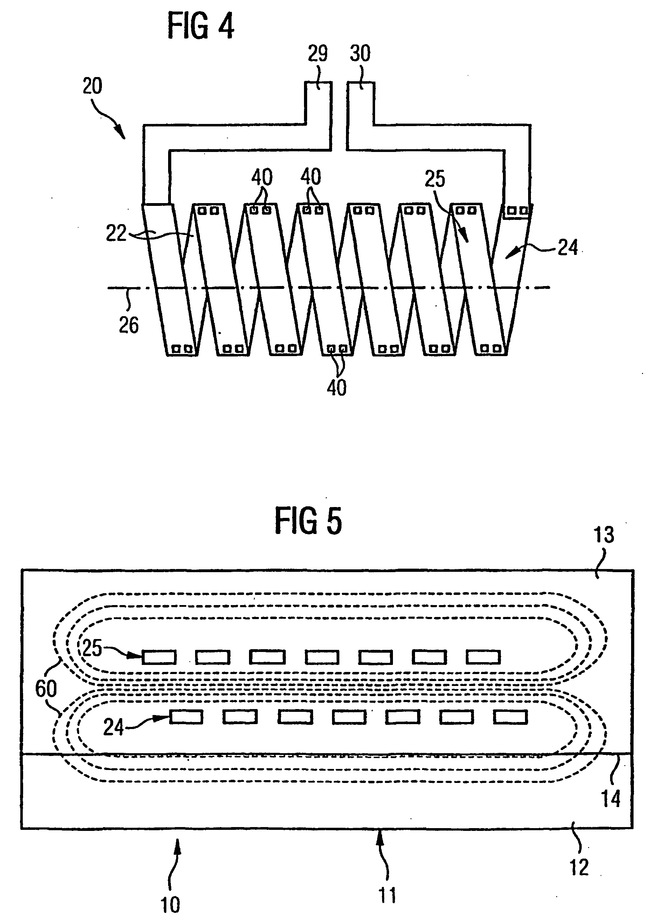

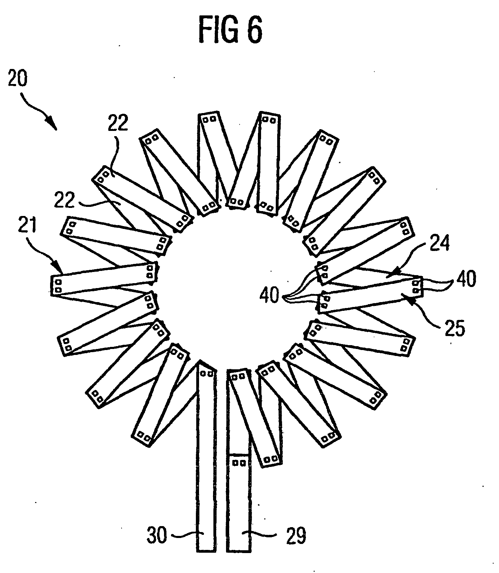

Wie sich weiterhin aus den Figuren 4 und 5 ergibt, ist die Spulenachse 26 der Spule 20 horizontal zur Substratoberfläche 14 ausgebildet. Dadurch ergibt sich nur ein geringer Durchgriff von magnetischen Streufeldern in das Substrat 12 hinein. Dies ist durch den in Figur 5 dargestellten Verlauf der magnetischen Feldlinien 60 verdeutlicht.

Auf Grund des mittels einer Standardmetallisierung herstellbaren großen Spulenquerschnitts 27 kann auf einen wie in der EP-A-0 725 407 beschriebenen Magnetkern verzichtet werden.

In Figur 6 ist eine weitere Ausführungsform einer erfindungsgemäßen Spule 20 dargestellt. Bei dieser Spule 20 weist die Spulenachse 26 eine zumindest in etwa geschlossene, kreisförmige Linie auf. Dadurch erhält auch die gesamte Spule 20 ein in etwa kreisförmiges Aussehen. Durch diese Spulenkonfiguration wird erreicht, daß neben der als geschlossene Linie ausgebildeten Spulenachse 26 auch der Spulenanfang 29 sowie das Spulenende 30 direkt benachbart zueinander liegen. Durch eine solche Ausgestaltung der Spule 20 kann die Spulengüte weiter verbessert werden, da der Streuanteil reduziert wird. Der grundsätzliche Aufbau der Spule 20 gemäß Figur 6 entspricht in etwa demjenigen der in den Figuren 2 bis 5 dargestellten Spule 20, so daß gleiche Bauelemente mit identischen Bezugsziffern bezeichnet sind und zur Vermeidung von Wiederholungen auf die Ausführungen zu diesem Ausführungsbeispiel verwiesen wird.

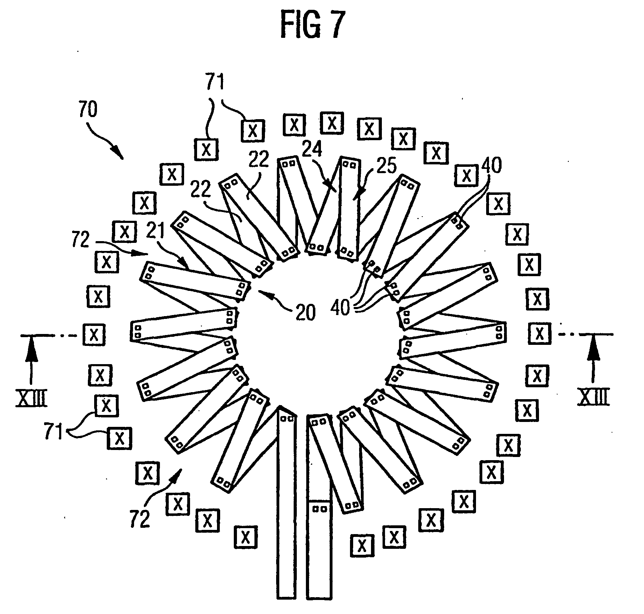

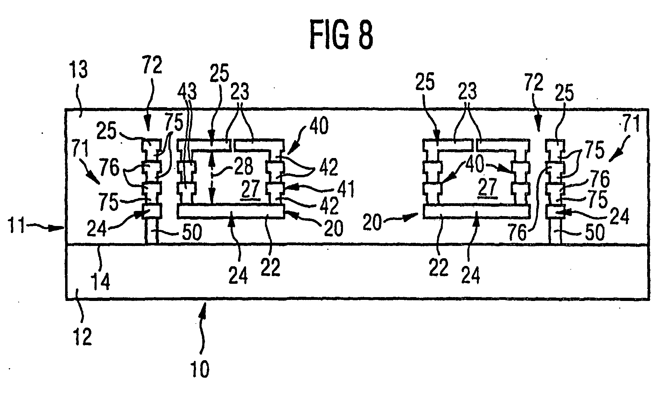

In den Figuren 7 und 8 ist nun ein Spulensystem 70 dargestellt, in dem eine oder mehrere Spulen 20 gemäß Figur 6 verwendet werden. Der besseren Übersicht halber ist nur eine einzige Spule 20 dargestellt. Die Spule 20 ist wiederum Bestandteil einer mikroelektronischen Schaltung 10 und innerhalb einer Oxidschicht 13 eines Chips 11 angeordnet, wobei sich die Oxidschicht 13 auf der Substratoberfläche 14 eines Substrats 12 befindet.

Um eine effiziente laterale Abschirmung der Spule 20 realisieren zu können, sind eine Reihe von Via-Stapeln 71 vorgesehen, die im Bereich außerhalb der Spulenperipherie 72 nebeneinander angeordnet und um die Spule 20 herum gelegt sind. Die Via-Stapel 71 erstrecken sich parallel zu den Via-Kontakten 40.

Ähnlich wie die Via-Kontakte 40 bestehen die Via-Stapel 71 aus zwei oder mehr Via-Elementen 75, zwischen denen sich Bestandteile 76 von Metallisierungsebenen befinden. Die unterste Metallisierungsebene ist wie bei der Spule 20 die Metallisierungsebene 24, während die oberste Metallisierungsebene wie bei der Spule 20 die Metallisierungsebene 25 ist. Für die Herstellung der Via-Stapel 71 kann somit auch die Standardmetallisierung, vorzugsweise die Standardmetallisierung mit Kupfer, verwendet werden. Die Via-Stapel 71 können gleichzeitig mit der Spule 20 hergestellt werden.

Im Unterschied zu den Via-Kontakten 40 der Spule 20 sind die Via-Stapel 71 über entsprechende Kontakte 50 mit dem Substrat 12 verbunden.

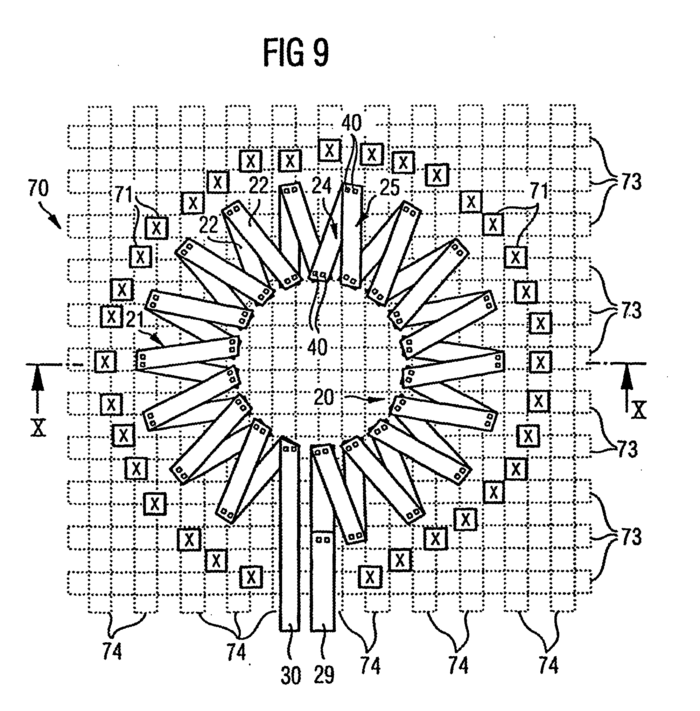

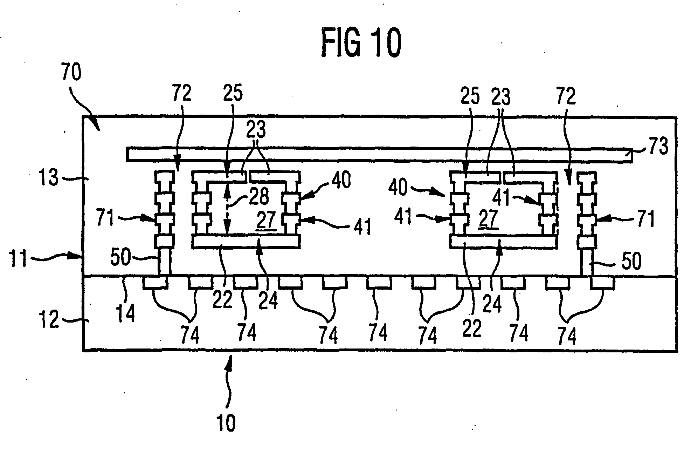

In den Figuren 9 und 10 ist schließlich eine im Hinblick auf die Figuren 7 und 8 weiterführende, modifizierte Ausführungsform eines Spulensystems 70 dargestellt. Dabei sind im Vergleich zu den Figuren 7 und 8 gleiche Bauelemente wiederum mit identischen Bezugsziffern bezeichnet worden.

Zusätzlich zu dem in den Figuren 7 und 8 dargestellten Spulensystem 70 weist das Spulensystem 70 gemäß den Figuren 9 und 10 eine obere Abschirmebene 73 sowie eine untere Abschirmebene 74 auf. Stehen bei der in Figur 10 dargestellten mikroelektronischen Schaltung 10 genügend Metallisierungsebenen zur Verfügung, kann die oberste Metallisierungsebene, im vorliegenden Fall die Abschirmebene 73, zum vertikalen Abschirmen der Spule 20 nach oben verwendet werden. Im vorliegenden Ausführungsbeispiel besteht die obere Abschirmebene 73 aus Metall. Zur Unterbindung von Wirbelströmen ist die obere Abschirmebene 73 als geschlitzte Fläche ausgebildet.

Für die Abschirmung der Spule 20 nach unten kann die untere Abschirmebene 74 verwendet werden, die beispielsweise als Poly-Siliziumschicht oder Struktur mit hochdotiertem Substrat ausgebildet sein kann. Ebenso wie die obere Abschirmebene 73 kann auch die untere Abschirmebene 74 als geschlitzte Fläche ausgebildet sein.

**Patentansprüche**

1. Spule zur Integration in eine mikroelektronische Schaltung (10) auf einem Chip, mit einer oder mehreren Windungen (21), wobei die Windung(en) (21) durch zumindest Segmente von zwei Leiterbahnen (22, 23), die in jeweils räumlich voneinander getrennten Metallisierungsebenen (24, 25) ausgebildet sind, sowie die diese Leiterbahn(en) (22) und/ oder Leiterbahnsegmente (23) verbindende Via-Kontakte (40) gebildet ist/sind, **dadurch gekennzeichnet**, däß jeder Via-Kontakt (40) aus einem Stapel (41) von zwei oder mehr übereinander angeordneten Via-Elementen (42) gebildet ist.

2. Spule nach Anspruch 1, **dadurch gekennzeichnet, daß** die Via-Kontakte (40) zumindest im wesentlichen senkrecht zu den Leiterbahnen (22) und/ oder Leiterbahnsegmenten (23) ausgerichtet sind.

3. Spule nach Anspruch 1 oder 2, **dadurch gekennzeichnet, daß** zumindest zwischen einzelnen Via-Elementen (42) eines Stapels (41) Bestandteile (43) einer Metallisierungsebene vorgesehen sind.

**4.** Spule nach einem der Ansprüche 1 bis 3, **dadurch gekennzeichnet, daß** die Leiterbahn(en) (22) und/oder die Leiterbahnsegmente (23) sowie die Via-Kontakte (40) den Querschnitt (27) der Spule (20) begrenzen.

**5.** Spule nach einem der Ansprüche 1 bis 4, **dadurch gekennzeichnet, daß** die die Windung (21) oder Windungen der Spule (20) bildende (n) Leiterbahn (en) (22) und/oder Leiterbahnsegmente (23) in einem Abstand von etwa 4 μm zueinander angeordnet sind.

**6.** Spule nach einem der Ansprüche 1 bis 5, **dadurch gekennzeichnet, daß** die Leiterbahn(en) (22) und/oder Leiterbahnsegmente 823) und/oder die Via-Elemente (42) und/oder die zwischen einzelnen Via-Elementen (42) vorgesehenen Bestandteile (43) einer Metallisierungsebene aus Kupfer, insbesondere aus elektrolytisch abgeschiedenem Kupfer, gebildet sind.

**7.** Spule nach einem der Ansprüche 1 bis 6, **dadurch gekennzeichnet, daß** die Spule (20) zur Integration in einer auf und/oder in einem Substrat (12) angeordneten mikroelektronischen Schaltung (10) ausgebildet ist und daß die Spulenachse (26) horizontal zur Substratoberfläche (14) ausgerichtet ist.

**8.** Spule nach einem der Ansprüche 1 bis 7, **dadurch gekennzeichnet, daß** der Spulenanfang (29) und das Spulenende (30) der Spule (20) benachbart zueinander angeordnet sind, so daß die Spulenachse (26) eine zumindest in etwa geschlossene Linie, insbesondere eine kreisförmige Linie, bildet.

**9.** Spulensystem zur Integration in eine mikroelektronische Schaltung 10, **gekennzeichnet durch** eine oder mehrere Spulen (20) nach einem der Ansprüche 1 bis 8.

**10.** Spulensystem nach Anspruch 9, **dadurch gekennzeichnet, daß** zur Abschirmung der Spule(n) (20) eine Anzahl von Via-Stapeln (71), die jeweils aus einem oder mehreren Via-Element(en) (75) gebildet sind, vorgesehen ist und daß die Via-Stapel (71) außerhalb der Spule(n) (20), insbesondere außerhalb der Spulenperipherie, um diese herum angeordnet sind.

**11.** Spulensystem nach Anspruch 10, **dadurch gekennzeichnet, daß** die Via-Stapel (71) in etwa senkrecht zur Spulenachse (26) ausgerichtet sind.

**12.** Spulensystem nach einem der Ansprüche 9 bis 11, **dadurch gekennzeichnet, daß** zumindest eine Abschirmebene (73, 74) zur vertikalen Abschirmung der Spule (20) vorgesehen ist.

**13.** Spulensystem nach Anspruch 12, **dadurch gekennzeichnet, daß** die Abschirmebene (73) als Metallebene ausgebildet ist.

**14.** Spulensystem nach Anspruch 12 oder 13, **dadurch gekennzeichnet, daß** die Abschirmebene (74) als Poly-Siliziumebene oder als Struktur mit einem hochdotierten Substrat ausgebildet ist.

**15.** Mikroelektronische Schaltung, mit einer Anzahl integrierter Bauelemente, wobei zumindest eines dieser Bauelemente als Induktivität ausgebildet ist, **dadurch gekennzeichnet, daß** das als Induktivität vorgesehene Bauelement als Spule (20) nach einem der Ansprüche 1 bis 8 und/oder als Spulensystem (70) nach einem der Ansprüche 9 bis 14 ausgebildet ist.

**16.** Mikroelektronische Schaltung nach Anspruch 15, **dadurch gekennzeichnet, daß** diese auf und/oder in einem Chip (11) ausgebildet ist und daß der Chip (11) aus einem Substrat (12) und wenigstens einer Oxidschicht (13) gebildet ist.

**17.** Mikroelektronische Schaltung nach Anspruch 16, **dadurch gekennzeichnet, daß** die Spule (20) und/oder das Spulensystem (70) innerhalb der Oxidschicht (13) angeordnet ist.

**Claims**

**1.** Coil for integration into a microelectronic circuit (10) on a chip, having one or more turns (21), the turn (s) (21) being formed by at least segments of two interconnects (22, 23), which are formed in metallization planes (24, 25) that are in each case spatially separate from one another, and also the via contacts (40) connecting said interconnect(s) (22) and/or interconnect segments (23), **characterized in that** each via contact (40) is formed from a stack (41) of two or more via elements (42) arranged one above the other.

**2.** Coil according to Claim 1, **characterized in that** the via contacts (40) are oriented at least essentially perpendicularly to the interconnects (22) and/or interconnect segments (23).

**3.** Coil according to Claim 1 or 2, **characterized in that** constituent parts (43) of a metallization plane are provided at least between individual via elements (42) of a stack (41).

**4.** Coil according to one of Claims 1 to 3, **characterized in that** the interconnect(s) (22) and/or the interconnect segments (23) and also the via contacts (40) delimit the cross section (27) of the coil (20).

**5.** Coil according to one of Claims 1 to 4, **characterized in that** the interconnect(s) (22) and/or interconnect segments (23) forming the turn (21) or turns of the coil (20) are arranged at a distance of about 4 μm from one another.

**6.** Coil according to one of Claims 1 to 5, **characterized in that** the interconnect(s) (22) and/or interconnect segments (23) and/or the via elements (42) and/or the constituent parts (43) of a metallization plane that are provided between individual via elements (42) are formed from copper, in particular from copper deposited electrolytically.

**7.** Coil according to one of Claims 1 to 6, **characterized in that** the coil (20) is formed for integration in a microelectronic circuit (10) arranged on and/or in a substrate (12), and **in that** the coil axis (26) is oriented horizontally with respect to the substrate surface (14). (

**8.** Coil according to one of Claims 1 to 7, **characterized in that** the coil start (29) and the coil end (30) of the coil (20) are arranged adjacent to one another, with the result that the coil axis (26) forms an at least approximately closed line, in particular a circular line.

**9.** Coil system for integration into a microelectronic circuit 10, **characterized by** one or more coils (20) according to one of Claims 1 to 8.

**10.** Coil system according to Claim 9, **characterized in that**, for the shielding of the coil(s) (20), provision is made of a number of via stacks (71) each formed from one or more via element(s) (75) and **characterized in that** the via stacks (71) are arranged outside the coil(s) (20), in particular outside the coil periphery, around the latter.

**11.** Coil system according to Claim 10, **characterized in that** the via stacks (71) are oriented approximately perpendicularly to the coil axis (26).

**12.** Coil system according to one of Claims 9 to 11, **characterized in that** provision is made of at least one shielding plane (73, 74) for the vertical shielding of the coil (20).

**13.** Coil system according to Claim 12, **characterized in that** the shielding plane (73) is formed as a metal plane.

**14.** Coil system according to Claim 12 or 13, **characterized in that** the shielding plane (74) is formed as a polysilicon plane or as a structure with a highly doped substrate.

**15.** Microelectronic circuit, having a number of integrated components, at least one of these components being formed as an inductance, **characterized in that** the component provided as an inductance is formed as a coil (20) according to one of Claims 1 to 8 and/or as a coil system (70) according to one of Claims 9 to 14.

**16.** Microelectronic circuit according to Claim 15, **characterized in that** it is formed on and/or in a chip (11), and **in that** the chip (11) is formed from a substrate (12) and at least one oxide layer (13).

**17.** Microelectronic circuit according to Claim 16, **characterized in that** the coil (20) and/or the coil system (70) is arranged within the oxide layer (13).

## Revendications

**1.** Bobine à intégrer dans un circuit (10) microélectronique sur une puce, comprenant une ou plusieurs spires (21), la ou les spires (21) étant constituées par au moins des segments de deux pistes (22, 23) conductrices qui sont formés dans des plans (24, 25) de métallisation, respectivement séparés l'un de l'autre dans l'espace, ainsi que par les contacts (40) de traversée reliant cette ou ces pistes (22) conductrices et/ou segments (23) de pistes conductrices, **caractérisée en ce que** chaque contact (40) de traversée est formé d'une pile (41) de deux ou plusieurs éléments (42) de traversée qui sont superposés.

**2.** Bobine suivant la revendication 1, **caractérisée en ce que** les contacts (40) de traversée sont dirigés au moins sensiblement perpendiculairement aux pistes (22) conductrices et/ou aux segments (23) de pistes conductrices.

**3.** Bobine suivant la revendication 1 ou 2, **caractérisée en ce qu'**il est prévu des parties (43) constituantes d'un plan de métallisation au moins entre des éléments (42) de traversée d'une pile (41 ).

**4.** Bobine suivant l'une des revendications 1 à 3, **caractérisée en ce que** la ou les pistes (22) conductrices et/ou les segments (23) de pistes conductrices, ainsi que les contacts (40) de traversée délimitent la section (27) transversale de la bobine (20).

**5.** Bobine suivant l'une des revendications 1 à 4, **caractérisée en ce que** la ou les pistes (22) conductrices et/ou les segments (23) de pistes conductrices formant la spire (21) ou les spires de la bobine (20) sont disposés à une distance mutuelle d'environ 4 μm.

6. Bobine suivant l'une des revendications 1 à 5, **caractérisée en ce que** la ou les pistes (22) conductrices et/ou les segments (23) de pistes conductrices et/ou les éléments (42) de traversée et/ou les parties (43) constituantes d'un plan de métallisation prévu entre les divers éléments (42) de traversée sont en cuivre, notamment en cuivre déposé par électrolyse.

7. Bobine suivant l'une des revendications 1 à 6, **caractérisée en ce que** la bobine (20) est constituée pour s'intégrer dans un circuit (10) microélectronique disposé sur et/ou dans un substrat (12), et **en ce que** l'axe (26) de la bobine est dirigé horizontalement par rapport à la surface (14) du substrat.

8. Bobine suivant l'une des revendications 1 à 7, **caractérisée en ce que** le début (29) et la fin (30) de la bobine sont disposés à proximité l'un de l'autre, de sorte que l'axe (26) de la bobine forme une ligne au moins à peu près fermée, notamment une ligne circulaire.

9. Système de bobine à intégrer dans un circuit (10) microélectronique, **caractérisé par** une ou plusieurs bobines (20) suivant l'une des revendications 1 à 8.

10. Système de bobine suivant la revendication 9, **caractérisé en ce que** pour la protection de la ou les bobines (20), il est prévu un certain nombre de piles (71) de traversée qui sont formées respectivement d'un ou de plusieurs éléments (75) de traversée, et **en ce que** les piles (71) de traversée sont disposées à l'extérieur de la ou des bobines (20), notamment à l'extérieur de la périphérie de la bobine, tout autour de celle-ci.

11. Système de bobine suivant la revendication 10, **caractérisé en ce que** les piles (71) de traversée sont dirigées à peu près perpendiculairement à l'axe (26) de la bobine.

12. Système de bobine suivant l'une des revendications 9 à 11, **caractérisé en ce qu'**il est prévu au moins un plan (73, 74) de protection pour la protection verticale de la bobine (20).

13. Système de bobine suivant la revendication 12, **caractérisé en ce que** le plan (73) de protection est constitué sous la forme d'un plan métallique.

14. Système de bobine suivant la revendication 12 ou 13, **caractérisé en ce que** le plan (74) de protection est constitué sous la forme d'un plan en polysilicium ou sous la forme d'une structure ayant un substrat très dopé.

15. Circuit microélectronique ayant un certain nombre de composants intégrés, au moins l'un de ces composants étant constitué en inductance, **caractérisé en ce que** le composant prévu comme inductance est constitué sous la forme d'une bobine (20) suivant l'une des revendications 1 à 8 et/ou sous la forme d'un système (70) de bobine suivant l'une des revendications 9 à 14.

16. Circuit microélectronique suivant la revendication 15, **caractérisé en ce qu'**il est constitué sur et/ou dans une puce (11), et **en ce que** la puce (11) est formée d'un substrat (12) et d'au moins une couche (13) d'oxyde.

17. Circuit microélectronique suivant la revendication 16, **caractérisé en ce que** la bobine (20) et/ou le système (70) de bobine est disposé au sein de la couche (13) d'oxyde.

# FIG 1

(Stand der Technik)

## FIG 2

## FIG 3

## FIG 4

## FIG 5

## FIG 6

# FIG 7

## FIG 8

EP 1 249 025 B1

# FIG 9

# FIG 10

EP 1 249 025 B1